# EUROPÄISCHE PATENTSCHRIFT

(11) **EP 2 920 247 B1**
(45) Veröffentlichungstag und Bekanntmachung des Hinweises auf die Patenterteilung: **06.04.2016**
(21) Anmeldenummer: 13783030.3
(22) Anmeldetag: 22.10.2013
(51) Int. Cl.: C08L 83/04, C09J 183/04, G02B 1/04, C08G 77/12

(54) **SCHLEIFBARE SILICONELASTOMERZUSAMMENSETZUNG UND DEREN VERWENDUNG**
ABRADABLE SILICONE ELASTOMER COMPOUND AND USE THEREOF
COMPOSITION D'ÉLASTOMÈRE SILICONE MEULABLE ET SON UTILISATION

(30) Priorität: 16.11.2012 DE 102012220954
(43) Veröffentlichungstag der Anmeldung: 23.09.2015
(73) Patentinhaber: Wacker Chemie AG, 81737 München (DE)
(72) Erfinder: KÖLLNBERGER, Andreas, 84375 Kirchdorf (DE)
(74) Vertreter: Mieskes, Klaus Theoderich
(86) Internationale Anmeldenummer: PCT/EP2013/072096
(87) Internationale Veröffentlichungsnummer: WO 2014/075879

(56) Entgegenhaltungen:
- EP-A1- 1 749 861
- EP-A2- 1 544 253
- EP-B1- 0 894 117
- WO-A1-2012/049020
- US-A1- 2002 161 140

## Beschreibung

Die vorliegende Erfindung betrifft eine Produktformulierung auf Basis von Silikonelastomerzusammensetzungen für das temporäre Verkleben eines zu schleifenden oder zu polierenden Werkstückes an ein Trägersubstrat, wobei die Silikonelastomerzusammensetzung nach Aushärtung schleifbar oder polierbar ist.

Der Begriff "temporäre Verklebung" steht für die Verbindung zweier Substrate, welche zu einem geeigneten Zeitpunkt wieder gelöst werden soll. Gegebenenfalls müssen Werkstücke für einen Schleifprozess mechanisch fixiert werden. Bei hochpreisigen Werkstücken wie z.B. Schmucksteinen, optischen Linsen, Kunstgegenständen oder Halbleiterwafern verursacht dies häufig Beschädigungen am Werkstück oder die Befestigung zeigt nicht die gewünschte Stabilität. Daher besteht ein Bedarf an alternativen Befestigungsmethoden. Eine Möglichkeit besteht darin das Werkstück über eine temporäre Verklebung zu fixieren. Da beim Prozess des Schleifens oder Polierens nicht vermeidbar ist, dass die Schleifeinrichtung auch mit dem Kleber in Kontakt kommen kann, muss auch der Kleber schleifbar sein, da es sonst beispielsweise zu Materialbrüchen führen würde oder die Schleifapparatur verschmutz oder beschädigt wird. Daneben ist eine gute Temperaturbeständigkeit bis über 300°C notwendig, um die durch das Schleifen oder Polieren verursachte Reibung und damit Temperaturerhöhung zu überstehen. Temperaturbeständigkeit ist zudem notwendig, da nachfolgende Prozessierungsschritte des Werkstückes in einem hohen Temperaturbereich erfolgen können. Auch Chemikalienbeständigkeit ist eine wichtige Eigenschaft für einen solchen Kleber wie beispielsweise gegen Reinigungschemikalien. Aktuelle Marktanforderungen für Halbleiterbauteile richten sich auf immer geringere Gesamthöhen. Eine Möglichkeit, die Gesamthöhe eines Formbauteils wie ein Chip zu verringern, ist es, die verwendeten Wafer zu dünnen. Dies erfolgt über einen Schleifprozess und kann vor oder nach der Formsingulation ("Dicing") durchgeführt werden.

Dieser Schritt führt jedoch zu einer Verringerung der strukturellen Festigkeit des Wafers. Dadurch können die großen, dünnen Wafer bei der Bearbeitung mit den üblicherweise verwendeten Geräten und Materialien, wie z.B. den heute verwendeten "dicing tapes", aufgrund mangelnder mechanischer Unterstützung, brechen. Zudem können die bis zu 100 µm oder mehr herausragenden Waferstrukturen ("Bumps") durch die heute verwendeten Tapes (Klebefilme) teilweise nicht vollständig bzw. hohlraumfrei umschlossen werden, so dass die verbleibenden Hohlräume beim Bearbeiten im Vakuum in der Regel zu einer Zerstörung oder Beeinträchtigung des dünnen Wafers führen. Eine mögliche verfahrenstechnische Lösung für dieses Problem ist, den Wafer über eine temporäre Klebeschicht mit einem harten Substrat zu verkleben (beispielsweise mit einem anderen Wafer oder einem Waferträger wie z.B. Glas), um seine mechanische Festigkeit zu erhöhen, anschließend die gewünschten Bearbeitungsprozesse durchzuführen, und danach den dann nur noch 10-100 µm dünnen Wafer wieder vom Substrat abzulösen. Das über die temporäre Klebeschicht angebundene Substrat dient dabei als mechanische Verstärkung während der Schleif- und nachgeschalteten Bearbeitungsprozesse.

Die spätere Nachbearbeitung des gedünnten Wafers umfasst auch die Schaffung von Resiststrukturen durch Plasmaätzen und Prozesse wie beispielsweise Metallplattieren und Rückstandsreinigen.

Weiter wichtige Aspekte sind die minimale Freisetzung von flüchtigen Nebenprodukten und die Viskosität der unvernetzten Siliconelastomerzusammensetzung, um beispielsweise die Kontaminationsgefahr und Gesundheitsgefährdung niedrig zu halten und ein geeignetes Auftragen auf das Werkstück zu ermöglichen. Zudem muss der Kleber nach dem Schleifen oder Polieren vom Werkstück einfach und möglichst rückstandsfrei ablösbar sein.

In der Halbleiterindustrie besteht daher Bedarf an einem Klebstoff für ein temporäres Wafer-Bonding-Verfahren, dessen Eigenschaften die Bearbeitung des Wafers ermöglicht, ohne dass dieser bricht oder beschädigt wird. Der Klebstoff muss für den Auftrag mit einem industriell praktikablem Verfahren (zum Beispiel Spritzbeschichten, Drucken, Tauchen, Rotationsbeschichten) geeignet sein, und sich zum gewünschten Zeitpunkt über geeignete Verfahren rückstandsfrei vom Wafer lösen lassen.

Die vor dem Dünnen notwendige Befestigung des stützenden Substrats am Wafer könnte idealerweise durch thermoplastische oder elastische Polymere erfolgen, wobei die Frontstrukturen des Wafers unterstützend umschlossen werden müssen.

Im Stand der Technik sind mehrere Möglichkeiten zur temporären Verklebung mit einem Träger beschrieben, sie weisen jedoch diverse Nachteile auf.

Eine Möglichkeit, den Halbleiterwafer auf einem Träger zu fixieren, stellen sogenannte "Adhesive Tapes" dar. EP 0838086 B1 beschreibt ein Band aus einem thermoplastischen Elastomer-Block-Copolymer zur Verwendung für die Verarbeitung von Halbleiter-Wafern. Die begrenzte Elastizität des Materials führt jedoch zu Problemen bei der Verwendung von Wafern, die Oberflächenstrukturen aufweisen ("gebumpte Wafer"). Die thermoplastischen Eigenschaften des Materials führen außerdem zu einer verminderten Hitzestabilität. Diese ist jedoch eine wichtige Voraussetzung für die sich an das Dünnen des Wafers ("back-side grinding") anschließende, Rückseitenprozesse (Plasmaverfahren, CVD, ...).

WO 2009/003029 A2 beansprucht thermoplastische organische Polymere (Imide, Amidimide und Amidimide-Siloxane) für die Verwendung als temporärer Klebstoff zwischen einem Wafer und einem Carrier. WO 2009/094558 A2 beschreibt die temporäre Verklebung eines Wafers und eines Carriers, wobei die Verklebung nicht über die gesamte Fläche erfolgt, sondern nur im Randbereich. Die Verklebung wird nach erfolgtem Schleifprozess und eventuellen Rückseitenprozessen, chemisch, photochemisch, thermisch oder thermo-mechanisch zerstört. EP0603514 A2 beschreibt eine Methode, um einen Halbleiterwafer zu dünnen, wobei das verwendete Klebstoffmaterial maximal für 200 °C geeignet ist. In der US-Anmeldung US2004/0121618 A1 wird eine Flüssigklebstoff, der für Spin-Coating-Prozesse geeignet ist, beschrieben, wobei dieser aus einem thermoplastischen Polyurethan, sowie Dimethylacetamide und Propylenglycolmonomethylether als Hauptkomponenten besteht. Alle diese Vorschläge zeigen den Nachteil verminderter Hitzestabilität des ausgehärteten Klebstoffs.

EP1089326 B1 beansprucht einen Träger für Wafer, der aus einem mit einer staubdichten Folie bedecktem Siliconelastomer besteht, wobei die Trennkraft zwischen der Folie und der Siliconschicht von 5 bis 500 g/25 mm (nach JIS K 6854) beträgt. Der Nachteil liegt darin, dass diese Folie vor der Verwendung des Trägers mit einem zusätzlichen Prozessschritt entfernt werden muss, damit der Klebstoff zugänglich wird.

Aufgabe der vorliegenden Anmeldung war daher die Bereitstellung eines geeigneten Klebstoff für das reversibele Fixieren von Werkstücken welcher nach Aushärtung schleifbar oder polierbar, temperatur- sowie chemikalienbeständig ist. Zudem musste er mit möglichst wenigen und einfachen Prozessschritten auftragbar sein und sich wieder unproblematisch vom Werkstück entfernen lassen ohne dabei das Werkstück oder die Schleif- oder Poliervorrichtung zu beschädigen oder zu verschmutzen. Eine weitere Anforderung an den Klebstoff war dessen mechanische Festigkeit gegenüber Druckbeanspruchung, die besonders dann wichtig ist, wenn verklebte dünne Werkstücke auf einer kleinen Fläche einer Druckbeanspruchung unterliegen.

Diese Aufgabe wurde überraschenderweise gelöst durch die erfindungsgemäßen additionsvernetzbaren Siliconelastomerzusammensetzungen, enthaltend
(A1) 1-10 Gew.% mindestens eines linearen Organopolysiloxans, das mindestens 2 SiC-gebundene Reste mit aliphatischen Kohlenstoff-Kohlenstoff-Mehrfachbindungen aufweist, wobei die mittlere Molmasse von (A1) höchstens 15.000 g/mol beträgt,
(A2) 1-20 Gew.% mindestens eines linearen Organopolysiloxans, das mindestens 2 SiC-gebundene Reste mit aliphatischen Kohlenstoff-Kohlenstoff-Mehrfachbindungen aufweist, wobei die mittlere Molmasse von (A2) mindestens 40.000 g/mol beträgt,
(B) 1-40 Gew.% mindestens eines Organopolysiloxans, das mindestens drei Si-gebundene Wasserstoffatome pro Molekül aufweist, mit einem Gehalt an Si-gebundenem Wasserstoff von 0,04 bis 1,7 Gew.% und einer mittleren Molmasse von höchstens 20.000 g/mol,
(D) 1 - 100 ppm (bezogen auf das Metall) eines Hydrosilylierungskatalysators,
(E) 50-99 Gew.% mindestens eines verzweigten Siliconharzes der allgemeinen Summenformel (I)

   (R³₃SiO_{1/2})ₗ (R⁴R³₂SiO_{1/2})ₜ (R⁴R³SiO)ᵤ (R³₂SiO)ₚ(R⁴SiO_{3/2})_{q}(R³SiO_{3/2})ᵣ (SiO_{4/2})ₛ (I),

   wobei
   R³ ein linearer aliphatischer Rest,
   R⁴ ein aliphatisch ungesättigter Rest mit einer terminalen C=C Doppelbindung,
   1, t, u, p, q, r und s ganze Zahlen
   bedeuten,
   wobei folgendes gilt:
      1≥0, t≥0, u≥0, p≥0, q≥0, r≥0 und s≥0; und
      der Gehalt an aliphatisch ungesättigten Gruppen in (E) liegt zwischen 0,2 und 10 mmol/g; und
(E) weist eine mittlere Molmasse von höchstens 10⁵ g/mol auf,
mit der Maßgabe, dass das Verhältnis der aus der Komponente (B) bereitgestellten Si-H-Gruppen zu den aus den Komponenten (A1), (A2) und (E) bereitgestellten aliphatisch ungesättigten Gruppen zwischen 0,5 und 5 liegt und das Verhältnis der dynamischen Viskosität der Silikonelastomerzusammensetzung bei den Scherraten 1 s⁻¹ und 100 s⁻¹ und einer Temperatur von 20°C höchstens 1,2 beträgt und nach Vernetzung eine Shore-D-Härte von mindestens 25 aufweist.

Die erfindungsgemäßen Siliconelastomerzusammensetzungen sind mit üblichen industriellen Verfahren auf die Substrate auftragbar (zum Beispiel Spritzbeschichten, Drucken, Tauchen, Rotationsbeschichten).

Weiterhin zeigen sie annähernd Newtonsches Fliessverhalten mit geringer Scherverdünnung (kein Gelzustand bei Nullscherung), um das Auftragen einer gleichmäßigen Schichtdicke über den ganzen Wafer oder Substrat zu gewährleisten. Die erfindungsgemäßen Siliconelastomerzusammensetzungen weisen ein Verhältnis der dynamischen Viskosität bei den Scherraten 1 s⁻¹ und 100 s⁻¹ bei 20°C von höchstens 1,2 auf. Bevorzugt höchstens 1,1; besonders bevorzugt höchstens 1,05. Die dynamische Viskosität bei 20°C und einer Scherrate von 1 s⁻¹ der erfindungsgemäßen Siliconelastomerzusammensetzungen beträgt zwischen 10 und 20.000 mPa·s, bevorzugt zwischen 50 und 10.000 mPa·s und besonders bevorzugt zwischen 500 und 5.000 mPa·s.

Die erfindungsgemäßen Siliconelastomerzusammensetzungen zeigen sehr geringe Anteile flüchtiger Bestandteile, um Kontaminationen und Blasenbildung bei der Bearbeitung, auch unter Vakuum und der gleichzeitigen Einwirkung von Hitze, zu verhindern. Wobei die Massendifferenz des ausgehärteten Silikonkautschuks in der thermogravimetrischen Analyse (TGA) - bei einer Aufheizrate von 10 K/min bis 300°C und einem Luft- oder Stickstoffstrom von 30 ml/min - zwischen Raumtemperatur und 300°C höchstens 2 Gew.%, bevorzugt höchstens 1 Gew.% und besonders bevorzugt höchstens 0,5 Gew.% beträgt. Weiterhin zeigen sie niedrige Nachbildungsraten flüchtiger Bestandteile.

Der erfindungsgemäße Siliconkautschuk wird nach dem Auftragen hergestellt durch Vernetzung der erfindungsgemäßen Siliconelastomerzusammensetzungen und bildet die reversible Klebeschicht zwischen Werkstück und Substrat.

Der so hergestellte vernetzte Siliconkautschuk zeigt eine Shore D Härte nach DIN 53505 zwischen 25 und 80, bevorzugt zwischen 25 und 75 und besonders bevorzugt zwischen 30 und 65, der Weiterreißwiderstand nach ASTM D624-B-91 mindestens 2 N/mm, bevorzugt mindestens 5 N/mm, die Reißdehnung nach DIN 53504-85S1 höchstens 100%, bevorzugt höchstens 50% und die Reißfestigkeit nach DIN 53504-85S1 höchstens 8 N/mm2 aufweist, bevorzugt höchstens 5 N/mm2. Die mechanische Festigkeit gegenüber einer Druckbeanspruchung wird durch den Biegemodul aus dem 3-Punkt Biegeversuch wiedergegeben. Der Biegemodul nach EN ISO 178 der erfindungsgemäßen Siliconkautschuke beträgt mindestens 30 N/mm2, bevorzugt mindestens 50 N/mm2 und besonders bevorzugt mindestens 70 N/mm2.

Vorteile der erfindungsgemäßen Siliconkautschuke sind, dass sie aufgrund der für ein Elastomer ungewöhnlich hohen Shore D Härte und der oben genannten Mechanikwerte schleifbar bzw. polierbar sind. Der im Vergleich zu anderen Siliconelastomeren deutlich erhöhte Elastizitätsmodul sorgt dafür, dass selbst ein dünnes Werkstück unter punktueller Druckbelastung nicht bricht oder beschädigt wird. Die erfindungsgemäßen Siliconkautschuke lassen sich zudem zum gewünschten Zeitpunkt über geeignete Verfahren rückstandsfrei vom Werkstück lösen. Bei der Trennung der Verbindung zwischen dem Wafer und dem Träger verbleibt die Siliconkautschukschicht meist komplett entweder auf der Seite des Trägers oder auf der Seite des Wafers. Das Entfernen der Siliconkautschukschicht kann beispielsweise mit Hilfe eines Klebetapes erfolgen, wobei die Siliconkautschukschicht nach Kontakt mit dem Klebetape mit diesem von der Wafer- bzw. Trägeroberfläche abgezogen wird. In einem alternativen Verfahren kann die Siliconkautschukschicht mit Hilfe geeigneter, dem Stand der Technik bekannten Lösungs- und Depolymerisierungsmitteln entfernt werden.

Die erfindungsgemäßen Siliconkautschuke weisen eine hohe Temperaturstabilität auf, >250°C über mehrere Stunden und bei Spitzen bis >300°. Bei einer Temperaturbelastung von 250°C über den Zeitraum von einer Stunde verändern sich die mechanischen Kennwerte nur minimal. Es wird ein Shore-Härteanstieg von maximal 5 Punkten, bevorzugt maximal 3 Punkten und besonders bevorzugt von maximal 2 Punkten beobachtet. Die Reißdehnung wird um maximal 5%, bevorzugt um maximal 3% geringer, die Reißfestigkeit verringert sich maximal um 5 N/mm², bevorzugt um maximal 3 N/mm² und besonders bevorzugt um maximal 1 N/mm². Der Weiterreißwiderstand verringert sich um maximal 3 N/mm, bevorzugt um maximal 2 N/mm und besonders bevorzugt um maximal 1 N/mm. Der Biegemodul verändert sich maximal um 10%, bevorzugt um maximal 5%.

Die erfindungsgemäßen vernetzbaren Siliconelastomerzusammensetzungen haben den Vorteil dass sie in einem einfachen Verfahren unter Verwendung leicht zugänglicher Ausgangsstoffe und damit wirtschaftlich hergestellt werden können. Zudem weisen sie als einkomponentige Formulierung bei 25°C und Umgebungsdruck eine gute Lagerstabilität auf und vernetzen erst bei erhöhter Temperatur rasch. Die erfindungsgemäßen Siliconzusammensetzungen haben den Vorteil, dass diese bei zweikomponentiger Formulierung nach Vermischen der beiden Komponenten eine vernetzungsfähige Siliconzusammensetzung ergeben, deren Verarbeitbarkeit über einen langen Zeitraum hinweg bei 25°C und Umgebungsdruck bestehen bleibt. Sie zeigen somit extrem lange Topfzeiten, und vernetzen erst bei erhöhter Temperatur rasch.

Werden die erfindungsgemäßen Siliconzusammensetzungen zweikomponentig formuliert, liegt der Vorteil darin, dass im Vergleich zu einkomponentigen Zusammensetzungen höhere Vernetzungsgeschwindigkeiten erreicht werden können, was zu kürzeren Prozesszeiten in der Produktion führen kann.

Die Verwendung der erfinderischen Silconelastomerzusammensetzungen ist sehr vielfältig, da sie neben dem temporären Verkleben wie beispielsweise bei der Wafer-Herstellung, auch für die Herstellung von Formkörpern, Verkleben allgemein, aber auch für optisch Anwendungen verwendet werden können. Die erfinderischen Silconelastomerzusammensetzungen können mit allen dem Stand der Technik bekannten Verfahren wie z.B. Verguss, Molding, Extrusion, etc. verarbeitet werden. Das Anwendungsgebiet erstreckt sich von Massen für Moldmaking-Anwendungen, der Herstellung von optischen Formteilen wie z.B. Linsen, Scheiben, Lichtwellenleiter über Massen für die Herstellung dünner Schichten oder Beschichtungen hin zu extrudierten Produkten wie z.B. Schläuche, Profile, etc.

Weiterhin haben die erfindungsgemäßen Siliconelastomerzusammensetzungen den Vorteil, dass sie eine hohe Transparenz aufweisen. Die Transmission im Wellenlängenbereich zwischen 400 und 800 nm beträgt > 90 %, bevorzugt > 95 %. Aus diesem Grund eignen sich diese Materialien für alle optischen Anwendungen wie zum Beispiel LED-Linsen oder Verklebung von transparenten Materialien. Auch für die Verklebung von nicht transparenten Materialien sind sie geeignet. In Kombination mit der hohen Shore D-Härte sind die aus den erfindungsgemäßen Massen hergestellten Produkte geeignet um daraus transparente Gegenstände oder Formkörper herzustellen, die bisher aus anderen transparenten Materialien hergestellt wurden wie beispielsweise Glas, Polycarbonat (PC), Polystyrol, Polyethylenterephthalat (PET), Polybutylenterephtalat (PBT), Polyethylenterephtalat Glycol-modifiziert (PETG), Polymethylmethacrylat (PMMA), Polyethylen (PE), Polypropylen (PP), etc. Die so hergestellten Formkörper können zudem Nachbearbeitet werden, beispielsweise durch Schleifen oder Polieren.

Bei den erfindungsgemäßen Siliconelastomerzusammensetzungen kann es sich um Einkomponenten-Siliconzusammensetzungen wie auch um Zweikomponenten-Siliconzusammensetzungen handeln. In letzterem Fall können die beiden Komponenten der erfindungsgemäßen Zusammensetzungen alle Bestandteile in beliebiger Kombination enthalten, im Allgemeinen mit der Maßgabe, dass eine Komponente nicht gleichzeitig Siloxane mit aliphatischer Mehrfachbindung, Siloxane mit Si-gebundenem Wasserstoff und Katalysator, also im Wesentlichen nicht gleichzeitig die Bestandteile (A1), (A2) (B) und (D) enthält. Vorzugsweise handelt es sich bei den erfindungsgemäßen Zusammensetzungen jedoch um Einkomponenten-Zusammensetzungen. Die erfindungsgemäßen Silconelastomerzusammensetzungen, insbesondere einkomponentige, werden durch Vermischen aller Bestandteile nach dem Stand der Technik hergestellt.

Die in den erfindungsgemäßen additionsvernetzenden Zusammensetzungen eingesetzten Verbindungen (A1), (A2) und (B) werden bekanntermaßen so gewählt, dass eine Vernetzung möglich ist. So weisen beispielsweise die Verbindungen (A1) und (A2) mindestens zwei aliphatisch ungesättigte Reste auf und (B) mindestens drei Si-gebundene Wasserstoffatome, oder die Verbindungen (A1 und (A2)) weisen mindestens drei aliphatisch ungesättigte Reste auf und (B) mindestens zwei Si-gebundene Wasserstoffatome.

Als Organosiliciumverbindungen (A1) und (A2), die SiC-gebundene Reste mit aliphatischen Kohlenstoff-Kohlenstoff-Mehrfachbindungen aufweisen, werden vorzugsweise lineare Organopolysiloxane aus Einheiten der allgemeinen Formel (II)

RₐR¹_{b}SiO_{(4-a-b)/2} (II)

eingesetzt, wobei
R unabhängig voneinander, gleich oder verschieden, ein von aliphatischen Kohlenstoff-Kohlenstoff-Mehrfachbindungen freien, organischen oder anorganischen Rest,
R¹ unabhängig voneinander, gleich oder verschieden einen einwertigen, substituierten oder nicht substituierten, SiC-gebundenen Kohlenwasserstoffrest mit mindestens einer aliphatischen Kohlenstoff-Kohlenstoff-Mehrfachbindung,
a 1, 2 oder 3 ist, und
b 1 oder 2 ist
bedeuten,
mit der Maßgabe, dass die Summe a + b kleiner oder gleich 3 ist und mindestens 2 Reste R¹ je Molekül vorliegen und
wobei die mittlere Molmasse von (A1) höchstens 20.000 g/mol, bevorzugt höchstens 18.000 g/mol und besonders bevorzugt höchstens 15.000 g/mol beträgt und,
und die mittlere Molmasse von (A2) mindestens 35.000 g/mol, bevorzugt mindestens 40.000 g/mol und besonders bevorzugt mindestens 45.000 g/mol beträgt.

Bei Rest R kann es sich um ein- oder mehrwertige Reste handeln, wobei die mehrwertigen Reste, wie beispielsweise bivalente, trivalente und tetravalente Reste, dann mehrere, wie etwa zwei, drei oder vier, Siloxy-Einheiten der Formel (II) miteinander verbinden.

Weitere Beispiele für R sind die einwertigen Reste -F, -Cl, - Br, OR², -CN, -SCN, -NCO und SiC-gebundene, substituierte oder nicht substituierte Kohlenwasserstoffreste, die mit Sauerstoffatomen oder der Gruppe -C(O)- unterbrochen sein können, sowie zweiwertige, beidseitig gemäß Formel (II) Si-gebundene Reste. Falls es sich bei Rest R um SiC-gebundene, substituierte Kohlenwasserstoffreste handelt, sind bevorzugte Substituenten Halogenatome, phosphorhaltige Reste, Cyanoreste, -OR², -NR²-, -NR²², -NR²-C(O)-NR²₂, -C(O)-NR²₂, -C(O)R², - C(O)OR², -SO₂-Ph und -C₆F₅. Dabei bedeuten R² unabhängig voneinander, gleich oder verschieden ein Wasserstoffatom oder einen einwertigen Kohlenwasserstoffrest mit 1 bis 20 Kohlenstoffatomen und Ph gleich dem Phenylrest.

Beispiele für Reste R sind Alkylreste, wie der Methyl-, Ethyl-, n-Propyl-, iso-Propyl-, n-Butyl-, iso-Butyl-, tert-Butyl-, n-Pentyl-, iso-Pentyl-, neo-Pentyl-, tert-Pentylrest, Hexylreste, wie der n-Hexylrest, Heptylreste, wie der n-Heptylrest, Octylreste, wie der n-Octylrest und iso-Octylreste, wie der 2,2,4-Trimethylpentylrest, Nonylreste, wie der n-Nonylrest, Decylreste, wie der n-Decylrest, Dodecylreste, wie der n-Dodecylrest, und Octadecylreste, wie der n-Octadecylrest, Cycloalkylreste, wie Cyclopentyl-, Cyclohexyl-, Cycloheptyl- und Methylcyclohexylreste, Arylreste, wie der Phenyl-, Naphthyl-, Anthryl- und Phenanthrylrest, Alkarylreste, wie o-, m-, p-Tolylreste, Xylylreste und Ethylphenylreste, und Aralkylreste, wie der Benzylrest, der α- und der β-Phenylethylrest.

Beispiele für substituierte Reste R sind Halogenalkylreste, wie der 3,3,3-Trifluor-n-propylrest, der 2,2,2,2',2',2'-Hexafluorisopropylrest, der Heptafluorisopropylrest, Halogenarylreste, wie der o-, m- und p-Chlorphenylrest, -(CH₂)-N(R²)C(O)NR²₂, - -(CH₂)ₙ-C(O)NR²₂, -(CH₂)ₙ-C(O)R², -(CH₂)ₙ-C(O)OR², -(CH₂)ₙ-C(O)NR²², - (CH₂)-C(O)-(CH₂)ₘC(O)CH₃, - (CH₂)-O-CO-R², - (CH₂)-NR²-(CH₂)ₘ-NR²₂, - (CH₂)ₙ-O-(CH₂)ₘCH (OH) CH₂OH , - (CH₂)ₙ (OCH₂CH₂)ₘOR², - (CH₂)ₙ-SO₂-Ph und - (CH₂)ₙ-O-C₆F₅, wobei R² und Ph der oben dafür angegebenen Bedeutung entspricht und n und m gleiche oder verschiedene ganze Zahlen zwischen 0 und 10 bedeuten.

Beispiele für R gleich zweiwertige, beidseitig gemäß Formel (II) Si-gebundene Reste sind solche, die sich von den voranstehend für Rest R genannten einwertigen Beispielen dadurch ableiten, dass eine zusätzliche Bindung durch Substitution eines Wasserstoffatoms erfolgt: -(CH₂)-, -CH(CH₃) -, -C(CH₃)₂-, -CH(CH₃)-CH₂-, -C₆H₄-, - CH(Ph)-CH₂-, -C(CF₃)₂-, -(CH₂)ₙ-C₆H₄-(CH₂)ₙ-, - (CH₂)ₙ-C₆H₄-C₆H₄-(CH₂)ₙ-, (CH₂O)ₘ, (CH₂CH₂O)ₘ, - (CH₂)ₙ-Oₓ-C₆H₄-SO₂-C₆H₄-Oₓ-(CH₂)ₙ-, wobei x 0 oder 1 ist, und Ph, m und n die voranstehend genannte Bedeutung haben.

Bevorzugt handelt es sich bei Rest R um einen einwertigen, von aliphatischen Kohlenstoff-Kohlenstoff-Mehrfachbindungen freien, SiC-gebundenen, gegebenenfalls substituierten Kohlenwasserstoffrest mit 1 bis 18 Kohlenstoffatomen, besonders bevorzugt um einen einwertigen, von aliphatischen Kohlenstoff-Kohlenstoff-Mehrfachbindungen freien, SiC-gebundenen Kohlenwasserstoffrest mit 1 bis 6 Kohlenstoffatomen, insbesondere um den Methyl- oder Phenylrest.

Bei Rest R¹ kann es sich um beliebige, einer Anlagerungsreaktion (Hydrosilylierung) mit einer SiH-funktionellen Verbindung zugängliche Gruppen handeln.
Falls es sich bei Rest R¹ um SiC-gebundene, substituierte Kohlenwasserstoffreste handelt, sind als Substituenten Halogenatome, Cyanoreste und -OR² bevorzugt, wobei R² die obengenannte Bedeutung hat.

Bevorzugt handelt es sich bei Rest R¹ um Alkenyl- und Alkinylgruppen mit 2 bis 16 Kohlenstoffatomen, wie Vinyl-, Allyl-, Methallyl-, 1-Propenyl-, 5-Hexenyl-, Ethinyl-, Butadienyl-, Hexadienyl-, Cyclopentenyl-, Cyclopentadienyl-, Cyclohexenyl-, Vinylcyclohexylethyl-, Divinylcyclohexylethyl-, Norbornenyl-, Vinylphenyl- und Styrylreste, wobei Vinyl-, Allyl- und Hexenylreste besonders bevorzugt verwendet werden.

Als Organopolysiloxane (B), die Si-gebundene Wasserstoffatome aufweisen, werden vorzugsweise lineare Organopolysiloxane aus Einheiten der allgemeinen Formel (III)

R_{c}H_{d}SiO_{(4-c-d)/2} (III)

eingesetzt, wobei
R die oben angegebene Bedeutung hat,
c 0,1 2 oder 3 ist und
d 0, 1 oder 2 ist,
mit der Maßgabe, dass die Summe von c + d kleiner oder gleich 3 ist und mindestens zwei Si gebundene Wasserstoffatome je Molekül vorliegen, sie einem Gehalt an Si-gebundenem Wasserstoff von 0,04 bis 1,7 Gew.% und einer mittleren Molmasse von höchstens 20.000 g/mol aufweisen.

Vorzugsweise enthält das erfindungsgemäß eingesetzte Organopolysiloxan (B) Si-gebundenen Wasserstoff im Bereich von 0,04 bis 1,7 Gewichtsprozent, bezogen auf das Gesamtgewicht des Organopolysiloxans (B). Besonders bevorzugt enthält die eingesetzte Komponente (B) zwischen 0,5 und 1,7 Gew.% Si-gebundenen Wasserstoff.

Die mittlere Molmasse von (B) beträgt höchstens 20.000 g/mol, besonders bevorzugten höchstens 10.000 g/mol.

Auch die Struktur, der den Bestandteil (B) bildenden Moleküle ist nicht festgelegt; insbesondere kann die Struktur eines höhermolekularen, also oligomeren oder polymeren SiH-haltigen Siloxans linear sein. Lineare Polysiloxane (B) sind vorzugsweise aus Einheiten der Formel R₃SiO_{1/2}, HR₂SiO_{1/2}, HRSiO_{2/2} und R₂SiO_{2/2} zusammengesetzt, wobei R die vorstehend angegebene Bedeutung hat.

Selbstverständlich können auch Mischungen unterschiedlicher, den Kriterien des Bestandteils (B) genügender Siloxane eingesetzt werden. Insbesondere können die den Bestandteil (B) bildenden Moleküle zusätzlich zu den obligaten SiH-Gruppen ggf. zugleich auch aliphatisch ungesättigte Gruppen enthalten. Besonders bevorzugt ist die Verwendung niedermolekularer SiH-funktioneller Verbindungen wie Tetrakis(dimethylsiloxy)silan und Tetramethylcyclotetrasiloxan, sowie höhermolekularer, SiH-haltiger Siloxane, wie Poly(hydrogenmethyl)siloxan und Poly(dimethylhydrogenmethyl)siloxan mit einer Viskosität bei 25°C von 10 bis 10 000 mPa•s, oder analoge SiH-haltige Verbindungen, bei denen ein Teil der Methylgruppen durch 3,3,3-Trifluorpropyl- oder Phenylgruppen ersetzt ist.

Bestandteil (B) ist vorzugsweise in einer solchen Menge in den erfindungsgemäßen vernetzbaren Siliconzusammensetzungen enthalten, dass das Molverhältnis von SiH-Gruppen zu aliphatisch ungesättigten Gruppen aus (A1), (A2) und (E) zwischen 0,5 und 5, besonders bevorzugt zwischen 0,7 und 3 liegt. Die erfindungsgemäß eingesetzten Komponenten (A1), (A2) und (B) sind handelsübliche Produkte bzw. nach in der Chemie gängigen Verfahren herstellbar.

Als Hydrosilylierungskatalysator (D), welche auch als Katalysatoren für die Vernetzung additionsvernetzender Silicone bezeichnet werden, können alle dem Stand der Technik bekannten Katalysatoren verwendet werden. Komponente (D) kann ein Platingruppenmetall sein, beispielsweise Platin, Rhodium, Ruthenium, Palladium, Osmium oder Iridium, eine metallorganische Verbindung oder eine Kombination davon. Beispiele für Komponente (D) sind Verbindungen wie Hexachloroplatin(IV)-säure, Platindichlorid, Platinacetylacetonat und Komplexe der besagten Verbindungen, die in einer Matrix oder einer kernschalenartigen Struktur eingekapselt sind. Zu den Platinkomplexen mit niedrigem Molekulargewicht der Organopolysiloxane gehören 1,3-Diethenyl-1, 1,3,3 - Tetramethyldisiloxan-Komplexe mit Platin. Weitere Beispiele sind Platinphosphitkomplexe, Platinphosphinkomplexe oder Alkylplatinkomplexe. Diese Verbindungen können in einer Harzmatrix eingekapselt sein.

Die Konzentration von Komponente (D) ist zum katalysieren der Hydrosilylierungsreaktion der Komponenten (A1), (A2), (E) und (B) bei Einwirkung ausreichend. Die Menge an Komponente (D) beträgt 1 - 100 ppm (bezogen auf das Metall) bevorzugt zwischen 1 und 25 ppm des Platingruppenmetalls, je nach Gesamtgewicht der Komponenten. Die Härtungsrate kann gering sein, wenn der Bestandteil des Platingruppenmetalls bei unter 1 ppm liegt. Die Verwendung von mehr als 100 ppm des Platingruppenmetalls ist unwirtschaftlich oder kann die Stabilität der Zusammensetzung verringern.

Unter der Verbindungsklasse (E) werden verzweigte Siliconharze verstanden, welche durch ihre chemische Struktur bereits ein dreidimensionales Netzwerk ausbilden. Sie werden mit der allgemeinen Summenformel (I) beschrieben

(R ³₃SiO_{1/2})ₗ(R⁴R₂SiO_{1/2})ₜ(R⁴RSiO)ᵤ(R³₂SiO)ₚ(R⁴SiO_{3/2})_{q}(R³SiO_{3/2})ᵣ(SiO_{4/2})ₛ (I)

wobei
R³ ein linearer aliphatischer Rest,
R⁴ ein aliphatisch ungesättigter Rest mit einer terminalen C=C Doppelbindung,
1, t, u, p, q, r und s ganze Zahlen
bedeuten,
wobei folgendes gilt:
1≥0, t≥0, u≥0, p≥0, q≥0, r≥0 und s≥0;
der Gehalt an aliphatisch ungesättigten Gruppen in (E) liegt zwischen 0,2 und 10 mmol/g.

Bevorzugte Reste R³ sind kürze (C1-C4) lineare aliphatische Reste und besonders bevorzugt ist der Methylrest. Bevorzugte Reste R⁴ sind kurze (C1-C4) lineare aliphatisch ungesättigte Reste, die eine terminale C=C Doppelbindung aufweisen, besonders bevorzugt ist der terminale Vinylrest.
In einer bevorzugten Ausführung sind die Indices 1≥0, t≥0, u=0, p=0, q≥0, r≥0 und s≥0, in einer besonders bevorzugten Ausführung sind die Indices 1≥0, t≥0, u=0, p=0, q=0, r=0 und s≥0. Der Gehalt an aliphatisch ungesättigten Gruppen liegt bevorzugt zwischen 0,5 und 5 mmol/g und besonders bevorzugt zwischen 0,8 und 4 mmol/g.

Die mittlere Molmasse dieser Verbindungsklasse (E) kann in weiten Grenzen zwischen 10² und 10⁶ g/mol variieren, bevorzugte mittlere Molmassen liegen zwischen 10² und 10⁵ g/mol, besonders bevorzugte mittlere Molmassen liegen zwischen 10³ und 5*10⁴ g/mol.

Die erfindungsgemäßen Siliconelastomerzusammensetzungen können optional alle weiteren Zusatzstoffe enthalten, die auch bisher zur Herstellung von additionsvernetzbaren Zusammensetzungen eingesetzt wurden. Beispiele für verstärkende Füllstoffe (F), die als Komponente in den erfindungsgemäßen Siliconzusammensetzungen eingesetzt werden können, sind pyrogene oder gefällte Kieselsäuren mit BET-Oberflächen von mindestens 50 m²/g sowie Ruße und Aktivkohlen wie Furnace-Ruß und Acetylen-Ruß, wobei pyrogene und gefällte Kieselsäuren mit BET-Oberflächen von mindestens 50 m²/g bevorzugt sind. Die genannten Kieselsäurefüllstoffe können hydrophilen Charakter haben oder nach bekannten Verfahren hydrophobiert sein. Beim Einmischen hydrophiler Füllstoffe ist die Zugabe eines Hydrophobierungsmittels erforderlich. Der Gehalt der erfindungsgemäßen vernetzbaren Zusammensetzung an aktiv verstärkendem Füllstoff liegt im Bereich von 0 bis 70 Gew.-%, vorzugsweise bei 0 bis 50 Gew.-%.

Die erfindungsgemäße Silconelastomerzusammensetzung kann wahlweise als Bestandteile weitere Zusätze (G) zu einem Anteil von bis zu 70 Gew.-%, vorzugsweise 0,0001 bis 40 Gew.-%, enthalten. Diese Zusätze können rheologische Additive, Korrosionsinhibitoren, Oxidationsinhibitoren, Lichtschutzmittel, flammabweisend machende Mittel und Mittel zur Beeinflussung der elektrischen Eigenschaften Dispergierhilfsmittel, Lösungsmittel, Haftvermittler, Pigmente, Farbstoffe, Weichmacher, organische Polymere, Hitzestabilisatoren usw. sein. Hierzu zählen Zusätze, wie Tone, Lithopone, Ruße, Graphit, Metalloxide, Metallcarbonate, -sulfate, Metallsalze von Carbonsäuren, Metallstäube, Fasern, wie Glasfasern, Kunststoffasern, Kunststoffpulver, Metallstäube, Farbstoffe, Pigmente usw.

Diese Füllstoffe können zudem wärmeleitend oder elektrisch leitend sein. Beispiele für wärmeleitende Füllstoffe sind Aluminiumnitrid; Bariumtitanat; Berylliumoxid; Bornitrid; Diamant; Grafit; Magnesiumoxid; partikuläres Metall wie beispielsweise Kupfer, Gold, Nickel oder Silber; Siliziumcarbid; Wolframcarbid; Zinkoxid und eine Kombination davon. Wärmeleitende Füllstoffe sind im Stand der Technik bekannt und im Handel erhältlich. Es können eine Kombination aus Füllstoffen mit verschiedenen Partikelgrößen und unterschiedlicher Partikelgrößenverteilung verwendet werden.

Die erfindungsgemäße Siliconelastomerzusammensetzung kann zusätzlich optional Lösungsmittel (H) enthalten. Es ist jedoch darauf zu achten, dass das Lösemittel keine nachteiligen Effekte auf das Gesamtsystem hat. Geeignete Lösungsmittel sind im Stand der Technik bekannt und im Handel erhältlich. Das Lösungsmittel kann beispielsweise ein organisches Lösungsmittel mit 3 bis 20 Kohlenstoffatomen sein. Zu den Beispielen für Lösungsmittel gehören aliphatische Kohlenwasserstoffe wie beispielsweise Nonan, Decalin und Dodecan; aromatische Kohlenwasserstoffe wie beispielsweise Mesitylen, Xylen und Toluen; Ester wie beispielsweise Ethylacetat und Butyrolacton; Ether wie beispielsweise n-Butylether und Polyethylenglycolmonomethylether; Ketone wie beispielsweise Methylisobutylketon und Methylpentylketon; Siliconfluide wie beispielsweise lineare, verzweigte und zyklische Polydimethylsiloxane und Kombinationen aus diesen Lösungsmitteln. Die optimale Konzentration eines bestimmten Lösungsmittels in der erfindungsgemäßen Siliconelastomerzusammensetzung kann durch Routineversuche leicht bestimmt werden. Je nach Gewicht der Verbindung kann die Menge des Lösungsmittels zwischen 0 und 95 % bzw. zwischen 1 und 95 % liegen.

Als weiter optionale Komponenten (K) können Inhibitoren und Stabilisatoren zugesetzt werden. Sie dienen der gezielten Einstellung der Verarbeitungszeit, Anspringtemperatur und Vernetzungsgeschwindigkeit der erfindungsgemäßen Siliconzusammensetzungen. Diese Inhibitoren und Stabilisatoren sind auf dem Gebiet der additionsvernetzenden Zusammensetzungen sehr gut bekannt. Beispiele gebräuchlicher Inhibitoren sind acetylenische Alkohole, wie 1-Ethinyl-1-cyclohexanol, 2-Methyl-3-butin-2-ol und 3.5-Dimethyl-1-hexin-3-ol, 3-Methyl-1-dodecin-3-ol, Polymethylvinylcyclosiloxane wie 1,3,5,7-Tetravinyltetramethyltetracyclosiloxan niedermolekulare Siliconöle mit Methylvinyl-SiO_{1/2}-Gruppen und/oder R₂vinylSiO_{1/2}-Endgruppen, wie Divinyltetramethyldisiloxan, Tetravinyldimethyldisiloxan, Trialkylcyanurate, Alkylmaleate, wie Diallylmaleat, Dimethylmaleat und Diethylmaleat, Alkylfumerate, wie Diallylfumarat und Diethylfumarat, organische Hydroperoxide wie Cumolhydroperoxid, tert-Butylhydroperoxid und Pinanhydroperoxid, organische Peroxide, organische Sulfoxide, organische Amine, Diamine und Amide, Phosphane und Phosphite, Nitrile, Triazole, Diaziridine und Oxime. Die Wirkung dieser Inhibitorzusätze (K) hängt von ihrer chemischen Struktur ab, so dass die Konzentration individuell bestimmt werden muss. Inhibitoren und Inhibitormischungen werden vorzugsweise in einem Mengenanteil von 0,00001 % bis 5 % bezogen auf das Gesamtgewicht der Mischung zugesetzt, bevorzugt 0,00005 bis 2 % und besonders bevorzugt 0,0001 bis 1 %.

Als weiter optionale Komponenten (L) können eine oder mehrere haftvermittelnde oder die Haftung verhindernde Substanzen zugesetzt werden. Auch eine Kombination von zwei oder mehreren haftvermittelnden und die Haftung verhindernde Substanzen ist möglich. Als Haftvermittler können Übergangsmetallchelate, im Besonderen Alkoxysilane bzw. einer Kombination aus Alkoxysilan und einem hydroxyfunktionellen Polyorganosiloxan eingesetzt werden. Außerdem können ungesättigte oder epoxyfunktionelle Verbindungen verwendet werden, beispielsweise 3-Glycidoxypropyl-alkoxy-alkylsilane oder (Epoxycyclohexyl)ethyl-alkoxy-alkylsilane. Auch ungesättigte organische Gruppen tragende Silane sind für diesen Zweck geeignet, wie beispielsweise 3-Methacryloyloxypropyl-alkoxysilane, 3-Acryloxypropyl-alkoxysilane, Vinyl-, Allyl-, Hexenyl- oder Undecenylalkoxysilane.

Beispiele für epoxyfunktionelle Silane sind 3-Glycidoxypropyltrimethoxysilan, 3-Glycidoxypropyltriethoxysilan, (Epoxycyclohexyl)ethyldimethoxysilan, (Epoxycyclohexyl)ethyldiethoxysilan und eine Kombination davon. Zu den Beispielen für geeignete ungesättigte Alkoxysilane gehören Vinyltrimethoxysilan, Allyltrimethoxysilan, Allyltriethoxysilan, Hexenyltrimethoxysilan, Undecylenyltrimethoxysilan, 3-Methacryloyloxypropyl trimethoxysilan, 3-Methacryloyloxypropyl-Triethoxysilan, 3-Acryloyloxypropyl-Trimethoxysilan, 3-Acryloyloxypropyl-Triethoxysilan und eine Kombination davon.

Funktionelle Siloxane können ebenfalls verwendet werden. Das Siloxan entspricht dem Reaktionsprodukt eines hydroxyterminierten Polyorganosiloxans mit einem oder mehreren oben beschriebenen Alkoxysilanen oder einer Abmischung des hydroxyterminierten Polyorganosiloxans mit einem oder mehreren der oben genannten funktionellen Silanen. Zum Beispiel kann eine Mischung aus 3-Glycidoxypropyltrimethoxysilan und dem Reaktionsprodukt aus hydroxyterminiertem Methylvinylsiloxan und 3-Glycidoxypropyltrimethoxysilan verwendet werden.

Diese Komponenten können auch als eine physikalische Aufmischung anstatt einem Reaktionsprodukt verwendet werden.

Weiterhin können Teilhydrolysate der oben beschriebenen funktionellen Silane verwendet werden. Diese werden üblicherweise entweder durch die Reaktion des Silans mit Wasser und anschließender Herstellung der Mischung oder durch Herstellung der Mischung mit Anschließender Teilhydrolyse hergestellt.

Zu den geeigneten Übergangsmetallchelaten gehören Titanate, Zirkonate wie beispielsweise Zirkoniumacetylacetonat, Aluminumchelate wie beispielsweise Aluminumacetylacetonat und eine Kombination davon. Übergangsmetallchelate und deren Herstellungsverfahren sind im Stand der Technik bekannt.

### Beispiele:

In den nachstehend beschriebenen Beispielen beziehen sich alle Angaben von Teilen und Prozentsätzen, falls nicht anders angegeben, auf das Gewicht. Sofern nicht anders angegeben, werden die nachstehenden Beispiele bei einem Druck der umgebenden Atmosphäre, also etwa bei 1.000 hPa, und bei Raumtemperatur, also bei etwa 20°C, bzw. bei einer Temperatur, die sich beim Zusammengeben der Reaktanden bei Raumtemperatur ohne zusätzliche Heizung oder Kühlung einstellt, durchgeführt. Im Folgenden beziehen sich alle Viskositätsangaben auf die dynamische Viskosität bei einer Temperatur von 20°C und einer Scherung von 1 s⁻¹. Die nachfolgenden Beispiele erläutern die Erfindung, ohne dabei beschränkend zu wirken. Alle Beispiele geben die Gesamtzusammensetzung der vernetzten Produkte wieder, ob diese als ein- oder zweikomponenten-Zusammensetzungen formuliert werden, spielt dabei keine Rolle.

Es werden folgende Abkürzungen verwendet:
- Kat.: Platinkatalysator
- Bsp.: Beispiel
- Nr.: Nummer
- PDMS: Polydimethylsiloxan
- Gew.%: entspricht Gewichtsprozent
- Shore A/D: Härte nach DIN 53505
- WRW: Weiterreißwiderstand nach ASTM D624-B-94 in N/mm
- Visko: dynamische Viskosität, Scherrate d
- RD: Reißdehnung nach DIN 53504-85S1 in %
- RF: Reißfestigkeit nach DIN 53504-85S1 in N/mm²

### Beispiel 1: Siliconelastomerzusammensetzung 1

5 Gew % eines vinylterminierten linearen PDMS mit einem mittleren Molekulargewicht von 8.000 g/mol
5 Gew.% eines vinylterminierten linearen PDMS mit einem mittleren Molekulargewicht von 110.000 g/mol
16 Gew.% eines linearen SiH-Kammvernetzers mit einem Wasserstoffgehalt von 0,75 Gew% mit einem mittleren Molekulargewicht von 3.000 g/mol
74 Gew.% eines verzweigten vinylgruppenhaltigen Siliconharzes mit einer mittleren Molmasse von 4.000 g/mol und einem Gehalt von aliphatisch ungesättigten Gruppen von 1 mmol/g
10 ppm Platinkatalysator bezogen auf das Metall

Der Verhältnis Si-H-Gruppen zu aliphatisch ungesättigten Gruppen ist: 1,6

### Beispiel 2: Siliconelastomerzusammensetzung 2

8 Gew % eines vinylterminierten linearen PDMS mit einem mittleren Molekulargewicht von 8.000 g/mol
5 Gew % eines vinylhaltigen, linearen PDMS mit seitenständigen Vinylgruppen und einem Molekulargewicht von 30.000 g/mol
6 Gew.% eines vinylterminierten linearen PDMS mit einem mittleren Molekulargewicht von 110.000 g/mol
18 Gew.% eines linearen SiH-Kammvernetzers mit einem Wasserstoffgehalt von 1,15 Gew% mit einem mittleren Molekulargewicht von 3.000 g/mol
63 Gew.% eines verzweigten vinylgruppenhaltigen Siliconharzes mit einer mittleren Molmasse von 4.000 g/mol und einem Gehalt von aliphatisch ungesättigten Gruppen von 1 mmol/g
10 ppm Platinkatalysator bezogen auf das Metall

Der Verhältnis Si-H-Gruppen zu aliphatisch ungesättigten Gruppen ist: 3,4

### Beispiel 3: Siliconelastomerzusammensetzung 3

7 Gew % eines vinylterminierten linearen PDMS mit einem mittleren Molekulargewicht von 8.000 g/mol
6 Gew.% eines vinylterminierten linearen PDMS mit einem mittleren Molekulargewicht von 110.000 g/mol
22 Gew.% eines linearen SiH-Kammvernetzers mit einem Wasserstoffgehalt von 1,15 Gew% mit einem mittleren Molekulargewicht von 3000 g/mol
65 Gew.% eines verzweigten vinylgruppenhaltigen Siliconharzes mit einer mittleren Molmasse von 4.000 g/mol und einem Gehalt von aliphatisch ungesättigten Gruppen von 1 mmol/g
10 ppm Platinkatalysator bezogen auf das Metall

Der Verhältnis Si-H-Gruppen zu aliphatisch ungesättigten Gruppen ist: 4,0

### Beispiel 4: Siliconelastomerzusammensetzung 4

5 Gew % eines vinylterminierten linearen PDMS mit einem mittleren Molekulargewicht von 8.000 g/mol
5 Gew.% eines vinylterminierten linearen PDMS mit einem mittleren Molekulargewicht von 110.000 g/mol
24 Gew.% eines linearen SiH-Kammvernetzers mit einem Wasserstoffgehalt von 1,15 Gew% mit einem mittleren Molekulargewicht von 3.000 g/mol
66 Gew.% eines verzweigten vinylgruppenhaltigen Siliconharzes mit einer mittleren Molmasse von 4.000 g/mol und einem Gehalt von aliphatisch ungesättigten Gruppen von 0,8 mmol/g
10 ppm Platinkatalysator bezogen auf das Metall

Der Verhältnis Si-H-Gruppen zu aliphatisch ungesättigten Gruppen ist: 4,8

### Beispiel 5: Siliconelastomerzusammensetzung 5

8 Gew % eines vinylterminierten linearen PDMS mit einem mittleren Molekulargewicht von 8.000 g/mol
11 Gew % eines vinylterminierten linearen PDMS mit einem mittleren Molekulargewicht von 16.000 g/mol
4 Gew.% eines vinylterminierten linearen PDMS mit einem mittleren Molekulargewicht von 110.000 g/mol
6 Gew.% eines linearen SiH-Kammvernetzers mit einem Wasserstoffgehalt von 1,15 Gew% mit einem mittleren Molekulargewicht von 3.000 g/mol
71 Gew.% eines verzweigten vinylgruppenhaltigen Siliconharzes mit einer mittleren Molmasse von 4.000 g/mol und einem Gehalt von aliphatisch ungesättigten Gruppen von 0,8 mmol/g
10 ppm Platinkatalysator bezogen auf das Metall

Der Verhältnis Si-H-Gruppen zu aliphatisch ungesättigten Gruppen ist: 0,9

### Beispiel 6: Siliconelastomerzusammensetzung 6 (Vergleichsbeispiel)

20 Gew % eines vinylterminierten linearen PDMS mit einem mittleren Molekulargewicht von 8.000 g/mol
20 Gew % eines vinylterminierten linearen PDMS mit einem mittleren Molekulargewicht von 16.000 g/mol
10 Gew.% eines linearen SiH-Kammvernetzers mit einem Wasserstoffgehalt von 1,15 Gew% mit einem mittleren Molekulargewicht von 3.000 g/mol
50 Gew.% eines verzweigten vinylgruppenhaltigen Siliconharzes mit einer mittleren Molmasse von 4.000 g/mol und einem Gehalt von aliphatisch ungesättigten Gruppen von 0,7
10 ppm Platinkatalysator bezogen auf das Metall

Der Verhältnis Si-H-Gruppen zu aliphatisch ungesättigten Gruppen ist: 2,6

In Tabelle 1 sind die Ergebnisse der Messungen zu der mechanischen Festigkeit der vernetzten Siliconkautschuke aufgeführt. Die Shore D-Härte wurde an einer 6 mm dicken Probe bestimmt, die zu diesem Zweck eine Stunde bei 200 °C vernetzt wurde.

**Tabelle 1**

| | **Shore D** | **WRW** | **RD** | **RF** | **erfindungsgemäß** |
|---|---|---|---|---|---|
| Bsp. 1 | 50 | 5 | 7 | 5 | ja |
| Bsp. 2 | 35 | 7 | 9 | 4 | ja |
| Bsp. 3 | 40 | 8 | 6 | 4 | ja |
| Bsp. 4 | 38 | 8 | 8 | 4 | ja |
| Bsp. 5 | 30 | 10 | 20 | 3 | ja |
| Bsp. 6 | 20 | 2 | 4 | 3 | nein |

Die Tabelle 2 zeigt die Ergebnisse der Viskositätsbestimmung für das Verhältnis der dynamischen Viskosität der Beispiele bei den Scherraten 1 s⁻¹ und 100 s⁻¹ und einer Temperatur von 20°C.

**Tabelle 2**

| | **Visko d=1/Visko d=100** | **3-Punkt Biegemodul** |
|---|---|---|
| Bsp. 1 | 1,04 | 150 |
| Bsp. 2 | 1,03 | 110 |
| Bsp. 3 | 1,03 | 130 |
| Bsp. 4 | 1,02 | 120 |
| Bsp. 5 | 1,02 | 80 |
| Bsp. 6* | 1,02 | 20 |

| | | |
|---|---|---|
| *nicht erfindungsgemäß | | |

## Patentansprüche

1. Additionsvernetzbare Siliconelastomerzusammensetzung, enthaltend
(A1) 1-10 Gew.% mindestens eines linearen Organopolysiloxans, das mindestens 2 SiC-gebundene Reste mit aliphatischen Kohlenstoff-Kohlenstoff-Mehrfachbindungen aufweist, wobei die mittlere Molmasse von (A1) höchstens 15.000 g/mol beträgt,
(A2) 1-20 Gew.% mindestens eines linearen Organopolysiloxans, das mindestens 2 SiC-gebundene Reste mit aliphatischen Kohlenstoff-Kohlenstoff-Mehrfachbindungen aufweist, wobei die mittlere Molmasse von (A2) mindestens 40.000 g/mol beträgt,
(B) 1-40 Gew.% mindestens eines Organopolysiloxans, das mindestens drei Si-gebundene Wasserstoffatome pro Molekül aufweist, mit einem Gehalt an Si-gebundenem Wasserstoff von 0,04 bis 1,7 Gew.% und einer mittleren Molmasse von höchstens 20.000 g/mol,
(D) 1 - 100 ppm (bezogen auf das Metall) eines Hydrosilylierungskatalysators,
(E) 50-99 Gew.% mindestens eines verzweigten Siliconharzes der allgemeinen Summenformel (I)
(R³₃SiO_{1/2})ₗ(R⁴R³₂SiO_{1/2})ₜ(R⁴R³SiO)ᵤ(R³₂SiO)ₚ(R⁴SiO_{3/2})_{q}(R³SiO_{3/2})ᵣ(SiO_{4/2})ₛ (I),
wobei
R³ ein linearer aliphatischer Rest,
R⁴ ein aliphatisch ungesättigter Rest mit einer terminalen C=C Doppelbindung,
1, t, u, p, q, r und s ganze Zahlen
bedeuten,
wobei folgendes gilt:
1≥0, t≥0, u≥0, p≥0, q≥0, r≥0 und s≥0; und
der Gehalt an aliphatisch ungesättigten Gruppen in (E) liegt zwischen 0,2 und 10 mmol/g; und
(E) weist eine mittlere Molmasse von höchstens 10⁵ g/mol auf,
mit der Maßgabe, dass das Verhältnis der aus der Komponente (B) bereitgestellten Si-H-Gruppen zu den aus den Komponenten (A1), (A2) und (E) bereitgestellten aliphatisch ungesättigten Gruppen zwischen 0,5 und 5 liegt und das Verhältnis der dynamischen Viskosität der Silikonelastomerzusammensetzung bei den Scherraten 1 s⁻¹ und 100 s⁻¹ und einer Temperatur von 20°C höchstens 1,2 beträgt und nach Vernetzung eine Shore-D-Härte von mindestens 25 aufweist.

2. Verfahren zur Herstellung von Silconelastomerzusammensetzungen gemäß Anspruch 1 **dadurch gekennzeichnet, dass** alle in Anspruch 1 genannten Komponenten miteinander vermischt werden.

3. Verwendung der Silconelastomerzusammensetzungen gemäß Anspruch 1 zur Herstellung von Formkörpern, Verkleben, temporäres Verkleben und für optische Anwendungen.

## Claims

1. Addition-crosslinkable silicone elastomer composition comprising
(A1) 1-10 % by weight of at least one linear organopolysiloxane containing at least 2 SiC-bonded radicals having aliphatic carbon-carbon multiple bonds, wherein the mean molar mass of (A1) is not more than 15,000 g/mol,
(A2) 1-20 % by weight of at least one linear organopolysiloxane containing at least 2 SiC-bonded radicals having aliphatic carbon-carbon multiple bonds, wherein the mean molar mass of (A2) is at least 40,000 g/mol,
(B) 1-40 % by weight of at least one organopolysiloxane containing at least three Si-bonded hydrogen atoms per molecule, having a content of Si-bonded hydrogen of from 0.04 to 1.7 % by weight and a mean molar mass of not more than 20,000 g/mol,
(D) 1 - 100 ppm (based on the metal) of a hydrosilylation catalyst,
(E) 50-99 % by weight of at least one branched silicone resin of the general empirical formula (I)
(R³₃SiO_{1/2})ₗ (R⁴R³₂SiO_{1/2})ₜ (R⁴R³SiO)ᵤ (R³₂SiO)ₚ (R⁴SiO_{3/2})_{q}-(R³SiO_{3/2})ᵣ(SiO_{4/2})ₛ (I),
wherein
R³ denotes a linear aliphatic radical,
R⁴ denotes an aliphatically unsaturated radical having a terminal C=C double bond,
l, t, u, p, q, r and s denote integers,
wherein the following apply:
1≥0, t≥0, u≥0, p≥0, q≥0, r≥0 and s≥0; and
the content of aliphatically unsaturated groups in (E) is between 0.2 and 10 mmol/g; and
(E) has a mean molar mass of not more than 10⁵ g/mol,
with the proviso that the ratio of the Si-H groups provided by component (B) to the aliphatically unsaturated groups provided by components (A1), (A2) and (E) is between 0.5 and 5 and the ratio of the dynamic viscosity of the silicone elastomer composition at shear rates of 1 s⁻¹ and 100 s⁻¹ and a temperature of 20°C is not more than 1.2 and after crosslinking has a Shore D hardness of at least 25.

2. Process for the preparation of silicone elastomer compositions according to Claim 1, **characterized in that** all the components mentioned in Claim 1 are mixed together.

3. Use of the silicone elastomer compositions according to Claim 1 for the production of moldings, adhesive bonding, temporary adhesive bonding and for optical applications.

## Revendications

1. Composition d'élastomère silicone réticulable par addition, contenant
(A) 1-10 % en poids d'au moins un organopolysiloxane linéaire qui comporte au moins 2 radicaux liés à SiC, comportant des liaisons multiples carbone-carbone aliphatiques, la masse molaire moyenne de (A1) étant au maximum de 15 000 g/mole,
(A2) 1-20 % en poids d'au moins un organopolysiloxane linéaire qui comporte au moins 2 radicaux liés par une liaison SiC, comportant des liaisons multiples carbone-carbone aliphatiques, la masse molaire moyenne de (A2) étant d'au moins 40 000 g/mole,
(B) 1-40 % en poids d'au moins un organopolysiloxane qui comporte par molécule au moins trois atomes d'hydrogène liés par une liaison Si, ayant une teneur en hydrogène lié à Si de 0,04 à 1,7 % en poids et une masse molaire moyenne d'au maximum 20 000 g/mole,
(D) 1-100 ppm (par rapport au métal) d'un catalyseur d'hydrosilylation,
(E) 50-99 % en poids d'au moins une résine silicone ramifiée de formule brute générale (I)
(R³₃SiO_{1/2})ₗ (R⁴R³₂SiO_{1/2})ₜ (R⁴R³SiO)ᵤ (R³₂SiO)ₚ (R⁴SiO_{3/2})_{q}-(R³SiO_{3/2})ᵣ (SiO_{4/2})ₛ (I),
dans laquelle
R³ représente un radical aliphatique linéaire,
R⁴ représente un radical à insaturation aliphatique, comportant une double liaison C=C terminale,
1, t, u, p, q, r et s représentent des nombres entiers,
où il s'applique que :
1≥0, t≥0, u≥0, p≥0 , q≥0, r≥0 et s≥0 ; et
la teneur en groupes à insaturation aliphatique de (E) est comprise entre 0,2 et 10 mmole/g et
(E) présente une masse molaire moyenne d'au maximum 10⁵ g/mole,
étant entendu que le rapport des groupes Si-H fournis par le composant (B) aux groupes à insaturation aliphatique fournis par les composants (A1), (A2) et (E) est compris entre 0,5 et 5 et le rapport de la viscosité dynamique de la composition d'élastomère silicone aux vitesses de cisaillement 1 s⁻¹ et 100 s⁻¹ et à une température de 20 °C est d'au maximum 1,2, et celle-ci présente après réticulation une dureté Shore D d'au moins 25.

2. Procédé pour la préparation de compositions d'élastomères silicone selon la revendication 1, **caractérisé en ce qu'**on mélange entre eux tous les composés nommés dans la revendication 1.

3. Utilisation des compositions d'élastomères silicone selon la revendication 1, pour la production de corps moulés, de collages, de collages temporaires et pour des applications optiques.
